# EUROPÄISCHE PATENTSCHRIFT

(11) **EP 2 713 685 B1**
(45) Veröffentlichungstag und Bekanntmachung des Hinweises auf die Patenterteilung: **19.04.2017**
(21) Anmeldenummer: 13185680.9
(22) Anmeldetag: 24.09.2013
(51) Int. Cl.: H05K 3/34

(54) **Verfahren zum Herstellen einer Lötverbindung und Schaltungsbauteil**
Method for creating a soldered connection and circuit component
Procédé de fabrication d'une liaison soudée et composant de circuit

(30) Priorität: 01.10.2012 DE 102012217915; 13.09.2013 DE 102013218423
(43) Veröffentlichungstag der Anmeldung: 02.04.2014
(73) Patentinhaber: ROBERT BOSCH GMBH, 70442 Stuttgart (DE)
(72) Erfinder: Herberholz, Timo, 70188 Stuttgart (DE); Fix, Andreas, 70439 Stuttgart (DE)

(56) Entgegenhaltungen:
- CN-A- 1 747 162
- US-A- 5 859 407
- US-A1- 2010 096 043
- US-A1- 2012 103 678

## Beschreibung

### Stand der Technik

Die Erfindung betrifft ein Verfahren zum Herstellen einer Lötverbindung nach dem Oberbegriff des Anspruchs 1.

Ein Verfahren nach dem Oberbegriff des Anspruchs 1 ist aus der US 2012/103678 A1 bekannt. Bei dem bekannten Verfahren wird in einem ersten Schritt eine metallische Schicht auf ein Trägerelement aufgebracht. Diese metallische Schicht wird anschließend durch eine erste Wärmebehandlung versintert. Anschließend erfolgt das Aufbringen einer Lotschicht sowie das Anordnen eines elektronischen Bauteils auf der Lotschicht. Zuletzt erfolgt in einer zweiten Wärmebehandlung einer Verflüssigung des Lotes unter Ausbildung der Lötverbindung.

Ein weiteres Verfahren ist aus der US 5,429,293 bekannt. Bei diesem bekannten Verfahren wird auf den lötbaren Bereich eines Schaltungsträgers, der in Form einer Leiterplatte ausgebildet ist, zunächst eine erste Lotschicht aufgebracht. Auf die erste Lotschicht wird anschließend eine zweite Schicht, bestehend aus einer Lotpaste mit hochtemperaturfesten Partikeln und Zusatzkomponenten, beispielsweise Flussmittel, aufgebracht. Anschließend wird der so ausgebildete Verbund einer Wärmebehandlung ausgesetzt, bei der zunächst die erste Schicht, die einen geringeren Schmelzpunkt aufweist als die zweite Schicht, aufgeschmolzen wird und sich mit der darüber liegenden, zweiten Schicht vermengt, wobei die zweite Schicht in festem Zustand bestehen bleibt. Dabei verbinden sich die verflüssigten Bestandteile der ersten Schicht mit den festen Bestandteilen der zweiten Schicht. Auf eine derart ausgebildete Leiterplatte können anschließend (elektronische) Bauteile aufgebracht werden, die in einem nachgeschalteten Lötverfahren, insbesondere einer Reflow-Lötung, anschließend mit der Leiterplatte verbunden werden. Nachteilig bei dem bekannten Verfahren ist, dass die Tendenz besteht, dass die Oberfläche der die Partikel enthaltenden zweiten Schicht Poren aufweist, die im Verbindungsbereich mit einem elektronischen Bauteil die Qualität der Lötverbindung herabsetzt. Insbesondere ist dadurch, dass die erste Schicht in Bezug zur Ebene der Leiterplatte unterhalb der zweiten Schicht angeordnet ist, nicht sichergestellt, dass bei der Wärmebehandlung die verflüssigte erste Schicht die Poren der oberhalb der ersten Schicht angeordneten zweiten Schicht vollständig ausfüllt.

Aus der CN 1 747 162 A ist darüber hinaus ein Verfahren zum Ausbilden einer Lötverbindung bekannt, bei dem auf einem elektronischen Bauteil in Form eines Chips metallische Schichten aufgebracht und anschließend einer ersten Wärmebehandlung unterzogen werden. Anschließend wird der so vorbehandelte Verbund in Kontakt mit einer Lotmittel enthaltenden zweiten Schicht gebracht, welche bereits auf einem Trägerelement angeordnet ist. Durch eine darauffolgende zweite Wärmebehandlung findet eine Verflüssigung der Lotschicht und einer Ausbildung der Lötverbindung statt.

Aus dem US 5,859,407 ist weiterhin ein Verfahren zum Ausbilden einer Lötverbindung bekannt, bei dem in einem ersten Schritt eine Metallisierung an einem Trägerelement ausgebildet wird, die anschließend durch eine erste Wärmebehandlung versintert. Anschließend wird noch nicht verflüssigtes Lotmittel in den Bereich der versinterten metallischen Schicht gebracht und durch eine anschließende zweite Wärmebehandlung und Verflüssigung des Lotes verbindet sich das Lot mit der versinterten metallischen Schicht. Der so vorbehandelte Verbund kann anschließend mit einem elektronischen Bauelement verbunden werden Weiterhin ist aus dem Stand der Technik das sogenannte Diffusionslöten bekannt, das eine bleifreie Verbindungstechnologie auf der Basis des Prinzips der isothermen Erstarrung darstellt. Dabei wird üblicherweise eine niedrig schmelzende Lotschicht zwischen zwei hochschmelzenden Metallschichten angeordnet. Bei einer Erhitzung reagiert die niedrig schmelzende Lotschicht unter Ausbildung intermetallischer Verbindungen, die einen Schmelzpunkt aufweisen, der höher ist als der des niedrig schmelzenden Lotes.

### Offenbarung der Erfindung

Ausgehend von dem dargestellten Stand der Technik liegt der Erfindung die Aufgabe zugrunde, ein Verfahren zum Herstellen einer Lötverbindung nach dem Oberbegriff des Anspruchs 1 derart weiterzubilden, dass eine qualitativ hochwertige Lötverbindung mit einem zu verbindenden Bauteil bei einem vereinfachten Prozessablauf erzielt werden kann. Insbesondere soll eine zumindest nahezu porenfreie Oberfläche der Verbindungsstelle bzw. Verbindungsschicht nach dem Ausbilden der Lötverbindung erzielt werden. Eine weitere Aufgabe besteht darin, unter Verwendung konventioneller Anlagentechnik eine Vielzahl unterschiedlicher Bauteile bei relativ geringer Prozessdauer und geringer thermischer Belastung der Bauteile verlöten zu können. Weiterhin soll die Temperaturstabilität durch eine Auslöttemperatur, die höher ist als die Prozesstemperatur, erhöht werden.

Diese Aufgabe wird erfindungsgemäß bei einem Verfahren zum Herstellen einer Lötverbindung mit den Merkmalen des Anspruchs 1 gelöst.

Das erfindungsgemäße Verfahren hat den Vorteil, dass im Verlauf einer einzigen Wärmebehandlung, bei der die aus Schaltungsträger und den beiden Schichten bestehende Anordnung erwärmt wird, zunächst die die Metallpartikel enthaltende Schicht unter Ausbildung einer Gitterstruktur versintert, und dass beim weiteren Erwärmen die oberhalb der Metallpartikel angeordnete, das Lotmittel enthaltende, zweite Schicht verflüssigt wird und dabei zumindest die an der Oberfläche vorhandenen Poren der Metallgitterstruktur ausfüllt. Dadurch lässt sich eine ebene bzw. glatte Oberfläche der Lötstellen erzielen, die eine qualitativ hochwertige Verbindung mit dem Anbindungsbereich eines elektronischen Bauteils ermöglicht.

Vorteilhafte Weiterbildungen des erfindungsgemäßen Verfahrens zum Herstellen einer Lötverbindung sind in den Unteransprüchen aufgeführt.

Als geeignete Materialien für die Metallpartikel haben sich Partikel aus Kupfer, Bronze, Nickel, Zink und Messing mit einer Partikelgröße zwischen 1µm und 50µm erwiesen.

Für die Lotmittelschicht werden insbesondere bleifreie Lotmittel verwendet. Die dabei erforderlichen Temperaturen zur Verflüssigung des Lotmittels betragen dabei typischerweise, je nach verwendetem Material, etwa maximal 200°C. Ein derartiger Herstellungsprozess, bei dem der Schaltungsträger mit den beiden Schichten einer Wärmebehandlung unterzogen wird, kann auf konventionellen Anlagen, wie diese beispielsweise beim Reflow-Löten verwendet werden, angewandt werden. Dabei werden die Schaltungsträger im Durchlaufverfahren durch den Reflow-Ofen (kontinuierlich) hindurchgefördert, wobei die maximale Prozesstemperatur im Reflow-Ofen beispielsweise 280°C beträgt und der Durchlauf maximal etwa zehn Minuten lang dauert.

Ganz besonders bevorzugt ist ein Verfahren, bei der die das Lotmittel enthaltende Schicht die die Metallpartikel enthaltende Schicht über den Rand der zuletzt genannten Schicht hinaus überdeckt. Dadurch wird sichergestellt, dass die gesamte Oberfläche, auch an den seitlichen Bereichen der die Metallpartikel enthaltenden Schicht, bei dem Verflüssigen der Lotmittelschicht in Wirkverbindung mit der Lotmittelschicht gelangt und somit alle Poren an der Oberfläche der die Metallpartikel enthaltende Schicht geschlossen werden.

Es kann jedoch auch vorgesehen sein, dass die das Lotmittel enthaltende Schicht die die Metallpartikel enthaltende Schicht nicht vollständig überdeckt, sondern einen Rand auf der die Metallpartikel enthaltene Schicht freilässt. Bei einer derartigen Ausbildung wird der Vorteil erzielt, dass beim Verflüssigen der Lotschicht insbesondere das Lotmittel nicht über den Bereich der die Metallpartikel enthaltenden Schicht seitlich herausragt, so dass eine besonders hohe Schaltungsdichte auf einem Schaltungsträger erzielt werden kann, da die Bauteile relativ nahe zueinander angeordnet werden können, ohne dass die Gefahr besteht, dass die Kontaktbereiche von nebeneinanderliegenden Bauteilen durch die Lotschicht kurzgeschlossen werden. Darüber hinaus haben auch verschiedene Druckgeometrien einen Einfluss auf die thermomechanischen Eigenschaften und somit auch auf die Lebensdauer einer Schaltung.

Eine wiederum alternative Ausgestaltung der Erfindung sieht vor, dass die die Metallpartikel enthaltende Schicht eine Anordnung aus mehreren Teilbereichen umfasst, und dass die das Lotmittel enthaltende Schicht die Anordnung mit den Teilbereichen vollständig überdeckt und eine geschlossene Fläche ausbildet. Hierbei können die Teilbereiche, je nach Erfordernissen der zu kontaktierenden Bauteile, eine unterschiedliche Form aufweisen. Beispielsweise können diese in Draufsicht quadratisch, oval oder rund ausgebildet werden. Bei einer derartigen Ausbildung wird durch die unterschiedlichen Teilbereiche eine sichere Auflage bzw. Anordnung eines elektronischen Bauteils im Bezug zum Schaltungsträger erreicht, während durch das die Teilbereiche umgebende Lotmittel eine besonders sichere Anbindung bzw. Verbindung zwischen dem Schaltungsträger und dem Bauteil ermöglicht wird.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: einen Ausschnitt aus einem mit einem elektronischen Bauteil bestückten Schaltungsbauteil und
- Fig. 2 bis Fig. 5: jeweils Draufsichten und Schnitte durch unterschiedliche Ausbildungen von Kontaktbereichen, wie sie zur Herstellung einer Lötverbindung gemäß Fig. 1 verwendet werden.

Gleiche Elemente bzw. Elemente mit gleicher Funktion sind in den Figuren mit gleichen Bezugsziffern versehen.

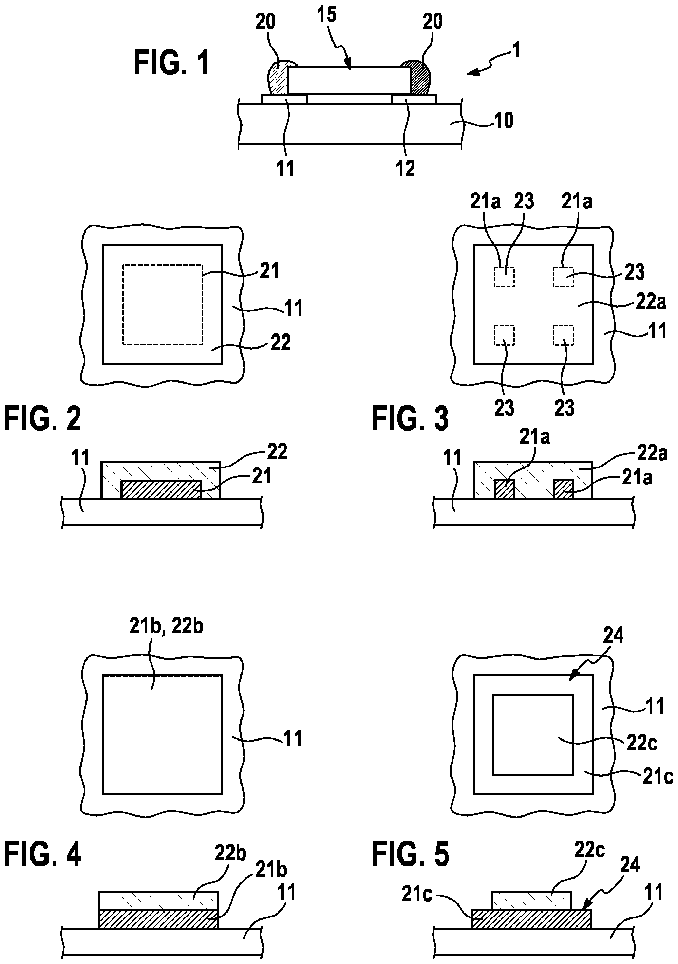

In der Fig. 1 ist ein Teilbereich eines Schaltungsbauteils 1 dargestellt, wie es beispielsweise in einem Kraftfahrzeug verwendet wird. Das Schaltungsbauteil 1 weist ein Trägerelement 10 in Form einer bedruckten Leiterplatte (PCB) auf, auf deren Oberseite elektrisch leitende Bereiche 11, 12 angeordnet sind. Die Bereiche 11, 12 dienen der elektrischen Kontaktierung eines insbesondere als SMD-Bauteil 15 ausgebildeten elektronischen Bauelements. Dabei wird das SMD-Bauteil 15 mit den Bereichen 11, 12 mittels einer Lötverbindung 20 mit zwei Lötstellen verbunden.

In den Fig. 2 bis 5 ist jeweils einer der beiden Bereiche 11, 12, im Ausführungsbeispiel jeweils der Bereich 11, dargestellt, wie er zur Vorbereitung der Lötverbindung 20 mit dem SMD-Bauteil 15 vorgesehen ist. In der Fig. 1 ist erkennbar, dass auf den Bereich 11 des Trägerelements 10 eine erste, in Draufsicht quadratische Schicht 21 aufgebracht ist, wobei die erste Schicht 21 aus Metallpartikeln und Zusatzstoffen besteht. Die erste Schicht 21 ist in Form einer Metallpaste ausgebildet. Bei den Metallpartikeln handelt es sich insbesondere, jedoch nicht einschränkend, um Partikel aus Kupfer, Bronze, Nickel, Zink, Messing oder ähnlichem, mit einer Partikelgröße zwischen 1µm und 50µm. Als Materialien für die Metallpartikel sind beispielsweise Eisen, Titan und deren Legierungen denkbar. Die Schichtdicke der ersten Schicht beträgt typischerweise zwischen 10µm und 150µm. Es können auch Mischungen aus den genannten Metallpartikeln verwendet werden.

Bei den Zusatzstoffen handelt es sich insbesondere um ein Flussmittel, jedoch können auch noch andere Zusatzstoffe alternativ oder ergänzend verwendet werden. So kann beispielsweise ein Trägermedium bzw. Dispergiermittel verwendet werden, das ggf. Flussmitteleigenschaften aufweist. Das Aufbringen der ersten Schicht 21 auf den Bereich 11 des Trägerelementes 10 erfolgt insbesondere durch Aufdrucken der ersten Schicht 21, es können alternativ, abhängig von den Randbedingungen jedoch auch andere, an sich bekannte Technologien verwendet werden.

Auf die erste Schicht 21 ist vorzugsweise nass in nass eine zweite, in Draufsicht ebenfalls quadratische Schicht 22 aufgebracht. Bei der zweiten Schicht 22 handelt es sich insbesondere um eine bleifreie Hart- oder Weichlotpaste, die, in Analogie zur ersten Schicht 21, auf die erste Schicht 21 sowie einen Randbereich um die erste Schicht 21 aufgedruckt wird. Die Schichtdicke der zweiten Schicht 22 beträgt zwischen 10µm und 150µm. Die zweite Schicht 22 überdeckt bei dem in der Fig. 1 dargestellten Ausführungsbeispiel somit die erste Schicht 21 vollständig und ragt seitlich noch über die erste Schicht 21 hinaus.

In der Fig. 3 ist der Fall dargestellt, bei der die erste Schicht 21a aus mehreren, im Ausführungsbeispiel jeweils eine quadratische Grundfläche aufweisenden Teilbereichen 23 besteht. Die Teilbereiche 23 bilden im Ausführungsbeispiel die Form einer 2x2-Matrix aus. Es liegt auch im Rahmen der Erfindung, die Form der Teilbereiche 23 sowie deren Anordnung und Anzahl unterschiedlich von der in der Fig. 3 dargestellten Anordnung auszubilden. Insbesondere können die Teilbereiche 23 beispielsweise eine ovale, runde oder n-eckige Form aufweisen. Die zweite Schicht 22a überdeckt die Teilbereiche 23 der ersten Schicht 21 a vollständig und ragt darüber hinaus noch über die Teilbereiche 23 hinaus. Insgesamt weist die zweite Schicht 22a, in Analogie zur zweiten Schicht 22 bei der Fig. 2, in Draufsicht eine quadratische Form auf.

In der Fig. 4 ist der Fall dargestellt, bei der die beiden Schichten 21 b, 22b, deckungsgleich übereinander angeordnet sind und jeweils eine gleich große, im Ausführungsbeispiel eine quadratische Fläche, aufweisen.

Zuletzt in der Fig. 5 der Fall dargestellt, bei der die erste Schicht 21 c eine quadratische Grundfläche aufweist, wobei die erste Schicht 21 c von der zweiten Schicht 22c lediglich teilweise überdeckt ist, da die zweite Schicht 22c eine geringere Grundfläche aufweist als die erste Schicht 21 c. Die zweite Schicht 22c weist ebenfalls eine quadratische Form (in Draufsicht) auf, und ist mit der ersten Schicht 21 c ausgerichtet, so dass sich ein von der zweiten Schicht 22c freier Randbereich 24 auf der ersten Schicht 21 c mit konstanter Breite ergibt.

Ein weiteres, nicht explizit abgebildetes Ausführungsbeispiel stellt beispielsweise eine Erweiterung des in Fig. 3 dargestellten Ausführungsbeispiels um die in Fig. 5 gezeigte, nicht vollständige Überdeckung der ersten Schicht 21c dar. In diesem Fall weist die erste Schicht 21 a eine Anordnung aus mehreren Teilbereichen 23 auf und die zweite Schicht 22a ist zwischen den Teilbereichen 23 angeordnet, überdeckt diese jedoch nur teilweise. Dabei sind sowohl Ausführungsformen mit einem von der zweiten Schicht 22a freien Randbereich 24 möglich als auch Ausführungsformen, bei denen der Randbereich der ersten Schicht 21a durch die zweite Schicht 22a bedeckt ist.

Die erste Schicht 21, 21 a bis 21 c und die zweite Schicht 22, 22a bis 22c bilden jeweils Kontaktierzonen für das SMD-Bauteil 15 aus. Das SMD-Bauteil 15 wird nach Ausbilden der in den Fig. 2 bis 5 dargestellten Schichten 21, 21 a bis 21 c und 22, 22a bis 22c mit dem SMD-Bauteil 15 bestückt, indem dieses mit oder ohne Anpresskraft auf die Oberseite der zweiten Schicht 22, 22a bis 22c aufgebracht wird.

Ein derart mit SMD-Bauteilen 15 bestücktes Trägerelement 10 wird anschließend einer Wärmebehandlung unterzogen. Eine derartige Wärmebehandlung findet insbesondere in einem aus dem Stand der Technik bereits bekannten Reflow-Ofen statt, bei dem die Trägerelemente 10 im Durchlaufverfahren durch den Reflow-Ofen durchgeschleust werden. Beispielhaft beträgt die Durchlaufzeit der Trägerelemente 10 durch den Reflow-Ofen zehn Minuten, und die maximale, im Reflow-Ofen herrschende Prozesstemperatur beträgt 280°C.

Beim Durchschleusen des Trägerelements 10 durch den Reflow-Ofen steigt die Temperatur der Schichten 21, 21a bis 21 c und 22, 22a bis 22c zu. Wesentlich dabei ist, dass beim Erreichen einer Temperatur von beispielsweise 180°C die Metallpartikel der ersten Schicht 21, 21 a bis 21 c versintern und dabei eine Hohlräume aufweisende Gitterstruktur ausbilden, die eine gewisse mechanische Stabilität aufweist. Dabei ist die zweite Schicht 22, 22a bis 22c noch im festen Zustand, d.h. nicht verflüssigt. Erst bei einer Temperatur von beispielsweise 200°C, je nach Art des verwendeten Lots, verflüssigt sich die zweite Schicht 22, 22a bis 22c. Typische maximale Schmelztemperaturen des Lots bzw. der zweiten Schicht 22, 22a bis 22c liegen dabei im Bereich von etwa 240°C, wobei die an der zweiten Schicht 22, 22a bis 22c erreichte Temperatur lediglich etwas oberhalb der Schmelztemperatur der zweiten Schicht 22, 22a bis 22c liegen sollte. Wesentlich dabei ist, dass das verflüssigte Material der zweiten Schicht 22, 22a bis 22c in die Hohlräume bzw. Poren der Gitterstruktur der versinterten ersten Schicht 21, 21a bis 21 c eindringt und diese verschließt. Insbesondere findet das Verschließen der Poren der Gitterstruktur der ersten Schicht 21, 21 a bis 21 c auch an der Oberfläche der ersten Schicht 21, 21 a bis 21 c statt, so dass nach dem Erstarren bzw. dem Durchlaufen des Reflow-Ofens das Material der zweiten Schicht 22, 22a bis 22c nicht nur die Lötverbindung 20 zum SMD-Bauteil 15 herstellt, sondern auch für eine porenfreie, d.h. glatte Oberfläche der Schichten 21, 21 a bis 21 c und 22, 22a bis 22c an der Verbindungs- bzw. Fügestelle zum Bauteil 15 sorgt.

Das soweit beschriebene Verfahren zum Herstellen einer Lötverbindung 20 kann in vielfältiger Art und Weise abgewandelt bzw. modifiziert werden.

Beispielsweise ist das erfindungsgemäße Verfahren nicht auf die Ausbildung einer Lötverbindung 20 zwischen einem elektronischen Bauelement 15 und einem Trägerelement 10 in Form einer Leiterplatte beschränkt. Das erfindungsgemäße Verfahren kann beispielsweise ebenfalls dazu eingesetzt werden, ein gesamtes Schaltungsbauteil 1 und eine Kühlplatte zu kontaktieren.

## Patentansprüche

1. Verfahren zum Herstellen einer Lötverbindung (20), bei dem auf ein Trägerelement (10) zwei Schichten (21; 21 a bis 21 c, 22; 22a bis 22c) aufgebracht werden, wobei die eine Schicht (21; 21 a bis 21 c) zumindest Metallpartikel und Zusatzstoffe, insbesondere Flussmittel, und die andere Schicht (22; 22a bis 22c) zumindest Lotmittel aufweist, wobei das Trägerelement (10) und die beiden Schichten (21; 21a bis 21c, 22; 22a bis 22c) anschließend einer Wärmebehandlung unterzogen werden, bei der die Schicht (22; 22a bis 22c) mit dem Lotmittel verflüssigt wird und in die Struktur der die Metallpartikel enthaltenden Schicht (21; 21 a bis 21 c) eindringt, wobei in einem ersten Schritt die zumindest die Metallpartikel enthaltende Schicht (21; 21a bis 21c) auf das Trägerelement (10) aufgebracht wird, wobei in einem daran anschließenden zweiten Schritt die andere, die zumindest das Lotmittel enthaltende Schicht (22; 22a bis 22c) in zumindest teilweiser Überdeckung auf die die Metallpartikel enthaltende Schicht (21; 21 a bis 21 c) aufgebracht wird, und wobei in einem dritten Schritt die Wärmebehandlung durchgeführt wird, wobei beide Schichten (21; 21a bis 21c, 22; 22a bis 22c) auf dem Trägerelement (10) aufgebracht sind,
**dadurch gekennzeichnet,**
**dass** durch die Wärmebehandlung zunächst die Metallpartikel der einen Schicht (21; 21 a bis 21 c) unter Bildung einer Hohlräume aufweisenden Gitterstruktur versintern und anschließend das Material der anderen Schicht (22; 22a bis 22c) verflüssigt wird und in die Hohlräume bzw. Poren der Gitterstruktur der einen Schicht (21; 21a bis 21c) eindringt.

2. Verfahren nach Anspruch 1,
**dadurch gekennzeichnet,**
**dass** das Material der anderen Schicht (22; 22a bis 22c) zumindest die an der Oberfläche der einen Schicht (21; 21 a bis 21 c) aufgrund der Gitterstruktur ausgebildeten Poren auffüllt.

3. Verfahren nach Anspruch 1 oder 2,
**dadurch gekennzeichnet,**
**dass** vor dem Durchführen der Wärmebehandlung in Überdeckung mit zumindest einem Teilbereich der einen Schicht (21; 21 a bis 21 c) ein Bauteil (15), insbesondere ein elektronisches Bauteil (15), auf der anderen Schicht (22; 22a bis 22c) angeordnet wird.

4. Verfahren nach einem der Ansprüche 1 bis 3,
**dadurch gekennzeichnet,**
**dass** als Metallpartikel für die eine Schicht (21; 21 a bis 21 c) Partikel aus Kupfer, Bronze, Nickel, Zink, Messing mit einer Partikelgröße zwischen 1µm und 50µm verwendet werden.

5. Verfahren nach einem der Ansprüche 1 bis 4,
**dadurch gekennzeichnet,**
**dass** die maximale Temperatur, auf die die andere Schicht (22; 22a bis 22c) erwärmt wird, knapp oberhalb der Schmelztemperatur der anderen Schicht (22; 22a bis 22c) liegt, vorzugsweise einer Temperatur von maximal 240°C.

6. Verfahren nach einem der Ansprüche 1 bis 5,
**dadurch gekennzeichnet,**
**dass** die andere Schicht (22; 22a) die eine Schicht (21; 21 a) über den Rand der einen Schicht (21; 21 a) hinaus überdeckt.

7. Verfahren nach einem der Ansprüche 1 bis 5,
**dadurch gekennzeichnet,**
**dass** die andere Schicht (22c) die eine Schicht (21 c) nur teilweise überdeckt und insbesondere einen Randbereich (24) auf der einen Schicht (21c) freilässt.

8. Verfahren nach einem der Ansprüche 1 bis 5,
**dadurch gekennzeichnet,**
**dass** die eine Schicht (21 a) eine Anordnung aus mehreren Teilbereichen (23) umfasst, und dass die andere Schicht (22a) die Teilbereiche (23) vollständig überdeckt und eine geschlossene Fläche ausbildet.

9. Verfahren nach einem der Ansprüche 1 bis 5,
**dadurch gekennzeichnet,**
**dass** die eine Schicht (21 a) eine Anordnung aus mehreren Teilbereichen (23) umfasst, und dass die andere Schicht (22a) die Teilbereiche (23) teilweise überdeckt.

## Claims

1. Method for creating a soldered connection (20), in which two layers (21; 21a to 21c, 22; 22a to 22c) are deposited onto a support element (10), wherein one layer (21; 21a to 21c) has at least metal particles and additives, in particular flux, and the other layer (22; 22a to 22c) has at least solder, wherein the support element (10) and the two layers (21; 21a to 21c, 22; 22a to 22c) then undergo heat treatment in which the layer (22; 22a to 22c) with the solder is melted and penetrates into the structure of the layer (21; 21a to 21c) containing the metal particles, wherein in a first step the layer (21; 21a to 21c) containing at least the metal particles is deposited onto the support element (10), wherein in a subsequent second step the other layer (22; 22a to 22c) containing at least the solder is deposited so as to at least partially cover the layer (21; 21a to 21c) containing the metal particles, and wherein a third step involves carrying out the heat treatment, both layers (21; 21a to 21c, 22; 22a to 22c) being deposited on the support element (10),
**characterized in that**
the heat treatment first sinters the metal particles of the first layer (21; 21a to 21c), forming a lattice structure having cavities, and then melts the material of the second layer (22; 22a to 22c) such that it penetrates into the cavities or pores of the lattice structure of the first layer (21; 21a to 21c).

2. Method according to Claim 1,
**characterized in that**
the material of the second layer (22; 22a to 22c) at least fills the pores formed at the surface of the first layer (21; 21a to 21c) owing to the lattice structure.

3. Method according to Claim 1 or 2,
**characterized in that**
prior to carrying out the heat treatment, a component (15), in particular an electronic component (15) is arranged on the second layer (22; 22a to 22c) so as to overlap at least a part region of the first layer (21; 21a to 21c).

4. Method according to one of Claims 1 to 3,
**characterized in that**
the metal particles used for the first layer (21; 21a to 21c) are particles of copper, bronze, nickel, zinc, brass with a particle size between 1 µm and 50 µm.

5. Method according to one of Claims 1 to 4,
**characterized in that**
the maximum temperature to which the second layer (22; 22a to 22c) is heated is just above the melting point of the second layer (22; 22a to 22c), preferably a temperature of at most 240°C.

6. Method according to one of Claims 1 to 5,
**characterized in that**
the second layer (22; 22a) covers the first layer (21; 21a) beyond the edge of the first layer (21; 21a).

7. Method according to one of Claims 1 to 5,
**characterized in that**
the second layer (22c) only partially covers the first layer (21c) and in particular exposes an edge region (24) on the first layer (21c).

8. Method according to one of Claims 1 to 5,
**characterized in that**
the first layer (21a) comprises an arrangement of multiple part regions (23), and **in that** the second layer (22a) completely covers the part regions (23) and forms a closed surface.

9. Method according to one of Claims 1 to 5,
**characterized in that**
the first layer (21a) comprises an arrangement of multiple part regions (23), and **in that** the second layer (22a) partially covers the part regions (23).

## Revendications

1. Procédé de fabrication d'une liaison brasée (20), dans lequel on dépose sur un élément de support (10) deux couches (21; 21a à 21c, 22; 22a à 22c), dans lequel une première couche (21; 21a à 21c) présente au moins des particules de métal et des additifs, en particulier un fondant, et l'autre couche (22; 22a à 22c) présente au moins un métal d'apport, dans lequel on soumet ensuite l'élément de support (10) et les deux couches (21; 21a à 21c, 22; 22a à 22c) à un traitement thermique, au cours duquel la couche (22; 22a à 22c) avec le métal d'apport est liquéfiée et pénètre dans la structure de la couche (21; 21a à 21c) contenant les particules de métal, dans lequel on dépose dans une première étape la couche (21; 21a à 21c) contenant au moins les particules de métal sur l'élément de support (10), dans lequel on dépose dans une deuxième étape suivante l'autre couche (22; 22a à 22c) contenant au moins le métal d'apport en recouvrement au moins partiel sur la couche (21; 21a à 21c) contenant les particules de métal, et dans lequel on exécute le traitement thermique dans une troisième étape, dans lequel les deux couches (21; 21a à 21c, 22; 22a à 22c) sont déposées sur l'élément de support (10),
**caractérisé en ce que**, par le traitement thermique, d'abord les particules de métal de la première couche (21; 21a à 21c) se frittent en formant une structure de grille présentant des cavités et ensuite le matériau de l'autre couche (22; 22a à 22c) se liquéfie et pénètre dans les cavités ou les pores de la structure de grille de la première couche (21; 21a à 21c).

2. Procédé selon la revendication 1, **caractérisé en ce que** le matériau de l'autre couche (22; 22a à 22c) remplit au moins les pores formés à la surface de la première couche (21; 21a à 21c) en raison de la structure de grille.

3. Procédé selon la revendication 1 ou 2, **caractérisé en ce qu'**avant l'exécution du traitement thermique on dispose, en recouvrement avec au moins une région partielle de la première couche (21; 21a à 21c), un composant (15), en particulier un composant électronique (15), sur l'autre couche (22;22a à 22c).

4. Procédé selon l'une quelconque des revendications 1 à 3, **caractérisé en ce que** l'on utilise comme particules de métal pour la première couche (21; 21a à 21c) des particules de cuivre, de bronze, de nickel, de zinc, de laiton avec une taille de particules comprise entre 1 µm et 50 µm.

5. Procédé selon l'une quelconque des revendications 1 à 4, **caractérisé en ce que** la température maximale, à laquelle on chauffe l'autre couche (22; 22a à 22c), se situe juste au-dessus de la température de fusion de l'autre couche (22; 22a à 22c), de préférence une température de 240°C maximum.

6. Procédé selon l'une quelconque des revendications 1 à 5, **caractérisé en ce que** l'autre couche (22; 22a à 22c) recouvre la première couche (21; 21a) au-delà du bord de la première couche (21; 21a).

7. Procédé selon l'une quelconque des revendications 1 à 5, **caractérisé en ce que** l'autre couche (22c) ne recouvre que partiellement la première couche (21c) et en particulier une région de bord de la première couche (21c).

8. Procédé selon l'une quelconque des revendications 1 à 5, **caractérisé en ce que** la première couche (21a) comprend un agencement de plusieurs régions partielles (23), et **en ce que** l'autre couche (22a) recouvre entièrement les régions partielles (23) et forme une surface fermée.

9. Procédé selon l'une quelconque des revendications 1 à 5, **caractérisé en ce que** la première couche (21a) comprend un agencement de plusieurs régions partielles (23), et **en ce que** l'autre couche (22a) recouvre en partie les régions partielles (23).
